# EUROPÄISCHE PATENTSCHRIFT

(11) **EP 1 657 820 B1**
(45) Veröffentlichungstag und Bekanntmachung des Hinweises auf die Patenterteilung: **09.01.2008**
(21) Anmeldenummer: 05110403.2
(22) Anmeldetag: 07.11.2005
(51) Int. Cl.: H03L 7/06, G01S 7/288, G01S 7/40

(54) **Verfahren und Vorrichtung zum Stabilisieren einer Frequenz**
Method and aparatus for stabilising a frequency
Procédé et appareil pour la stabilisation de la fréquence

(30) Priorität: 12.11.2004 DE 102004054667
(43) Veröffentlichungstag der Anmeldung: 17.05.2006
(73) Patentinhaber: Hella KGaA Hueck & Co., 59552 Lippstadt (DE)
(72) Erfinder: Wixforth, Thomas, 33330 Gütersloh (DE)

(56) Entgegenhaltungen:
- DE-A1- 3 410 167
- DE-A1- 10 005 558
- US-A- 4 600 889
- US-A1- 2003 222 708
- US-B1- 6 522 868

## Beschreibung

Die Erfindung betrifft Verfahren zur Stabilisierung einer Soll- Frequenz eines Oszillators für hochfrequente Wellen gemäß dem Oberbegriff des Anspruchs 1 sowie eine Vorrichtung zur Durchführung des Verfahrens.

Solche hochfrequente Wellen werden z.B. im Automobilbereich für Radarsysteme eingesetzt, die z.B. für eine Abstandskontrolle oder eine Datenübertragung genutzt werden. Hierbei ist eine Einhaltung des Soll- Frequenz - Bereichs von großer Bedeutung, weil die Zulassungsbedingungen für den Funkverkehr eine nur geringe Schwankungsbreite erlauben. Ohne besondere Maßnahmen verändert sich aber die Frequenz infolge von z.B. nichtlinearem Verhalten der Frequenz in Abhängigkeit von der Spannung, Temperaturschwankungen, Alterung, Spannungsschwankungen und/oder Schwankungen der Last. Diese Veränderung der Frequenz ist unerwünscht und muss entsprechend korrigiert werden.

Die DE 100 05 558 A1 beschreibt eine Datenübertragung für Kraftfahrzeuge mit einer ersten und einer zweiten Sender/Empfängereinheit, wobei die zweite in einer relativ zum Fahrzeug bewegbaren Transpondereinheit angeordnet ist. Die erste Sender/Empfängereinheit ist eine Radareinheit für eine Abstandsmessung, die um ein zweikanaliges Datenübertragungssystem erweitert ist. Die zweite Sender/Empfängereinheit ist ebenfalls eine zweikanalige Datenübertragungseinheit. Die Frequenzen für die zweikanalige Kommunikation des Datenübertragungssystems sind so gewählt, dass ihre Differenz eine Zwischenfrequenz ergibt, die mit handelsüblichen Bauteilen in je einem Überlagerungsempfänger verarbeitet werden können. Eine mögliche Frequenzdrift der beiden Frequenzen wird erst bei der Zwischenfrequenz kompensiert. Eine Vorrichtung oder ein Verfahren zur Einhaltung der Soll- Frequenzen wird nicht beschrieben.

Aus der DE 34 10 167 C2, von der die Erfindung ausgeht, ist eine Anordnung zur Frequenzstabilisierung eines Impatt- Sendeoszillators bekannt, bei der Empfangssignale mit dem frequenzstabilisierten Signal eines Lokaloszillators auf eine Zwischenfrequenz herabgemischt werden. Hierfür spricht das Sendesignal zum Teil in den Empfängerkreis über, wo ein ZF- Signal erzeugt wird, das zum einen auf einen Tiefpass und zum anderen auf einen Hochpass geführt wird. Bei zu hoher oder zu niedriger ZF- Istfrequenz werden entsprechende pulsförmige Stellsignale zwischengespeichert und an einen Regler gegeben, der die Grundeinstellung eines dem hierfür ausgeschalteten Impatt- Oszillator zugeordneten Modulators verstellt. Der Regler enthält einen digitalen Zähler, dessen Stand durch die Stellsignale erhöht bzw. erniedrigt wird, wobei der Zählerstand in eine Gleichspannung für die Grundeinstellung des Modulators gewandelt wird. Diese bekannte Anordnung ist sehr aufwändig.

Aufgabe der Erfindung ist es, ein einfaches Verfahren zum Stabilisieren einer SollFrequenz eines Oszillators für hochfrequente Wellen sowie eine Vorrichtung gemäß dem Verfahren zu schaffen.

Die Aufgabe ist durch die Merkmale des Anspruchs 1 gelöst. Dadurch dass die tatsächliche Frequenz des Oszillators mit einer Referenz verglichen und gegebenenfalls korrigiert wird, wobei eine erste Frequenz fest vorgegeben wird, und dass die Frequenz der Referenz durch Vervielfachung der ersten Frequenz erzeugt wird, sind außer dem eigentlichen Sender nur wenige zusätzliche Bauteile erforderlich, um den Soll- Frequenz - Bereich des Oszillators sicher zu stabilisieren. Denn so steht immer eine sichere, konstante Taktfrequenz zur Verfügung, die durch Vervielfachung auf die SollFrequenz als zuverlässige Referenz verwendet werden kann.

Die Unteransprüche betreffen die vorteilhafte Ausgestaltung der Erfindung.

Eine Soll- Frequenz von 24 bis 24,35 GHz soll für Radarsysteme von Kraftfahrzeugen genutzt werden.

Die ersten Frequenzen nach Anspruch 3 sind preiswert, einfach und genau durch Prozessoren oder quarzgesteuerte Oszillatoren zu erzeugen.

Die Vervielfachung nach Anspruch 4 ist bevorzugt und mit allgemein erhältlichen Bauteilen durchführbar.

Das Ansteuern nach den Ansprüchen 5 bis 7 schließt die gegenseitige Störung des normalen Sende- und Empfangsbetriebs einerseits und des Kalibriervorgangs andererseits aus.

Entsprechendes gilt für die Vorrichtung nach den Ansprüchen 8 bis 14.

Die Erfindung wird anhand eines vereinfacht dargestellten Ausführungsbeispiels weiter erläutert. Es zeigen
Figur 1 eine Schaltung eines erfindungsgemäßen Oszillators mit Referenzoszillator sowie Sende- und Empfangseinheit,
Figur 2 ein Beispiel einer Schaltung des Referenzoszillators und
Figur 3 ein anderes Beispiel einer Schaltung des Referenzoszillators.

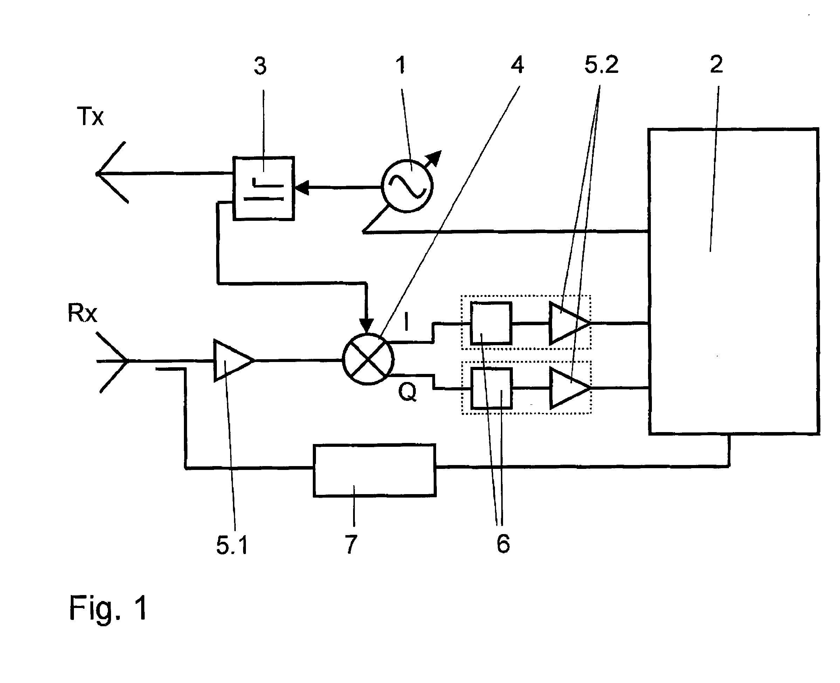

Wie aus Figur 1 ersichtlich ist ein spannungsgesteuerter Oszillator 1 einer Sende- und Empfangseinheit elektrisch mit einer Signalverarbeitungseinheit 2 verbunden. Der Oszillator 1 ist über einen Koppler 3 an eine Sendeantenne Tx angeschlossen. Der Koppler 3 ist weiterhin mit einem Mischer 4 verbunden.

Eine Empfangsantenne Rx ist über einen Verstärker 5.1 an den Mischer 4 angeschlossen, dessen Inphase I und dessen Quadraturphase Q jeweils separat über ein Filter 6 und einen Verstärker 5.2 an die Signalverarbeitungseinheit 2 angeschlossen sind.

Ein Referenzoszillator 7 ist steuerungstechnisch an die Signalverarbeitungseinheit 2 angeschlossen. Ein Ausgang des Referenzoszillators 7, der ein Signal in der Soll- Frequenz abgibt, ist an den Anschluss der Empfangsantenne Rx gekoppelt.

Alternativ zu dem in Figur 1 dargestellten Beispiel ist es auch möglich, dass die Sende- und Empfangseinheit mehrere Empfangsteile aufweist. Das Signal wird dann in einen der Empfangsteile eingeleitet, der für den Kalibriervorgang abschaltbar ist.

Weiterhin können mehrere statt nur einem Mischer 4 angeordnet sein.

Das Signal des Referenzoszillators 7 kann an einer beliebigen Stelle des Empfangsteils oder eines der Empfangsteile eingekoppelt werden, also z.B. in die Empfangsantenne Rx oder hinter dem Verstärker 5.1.

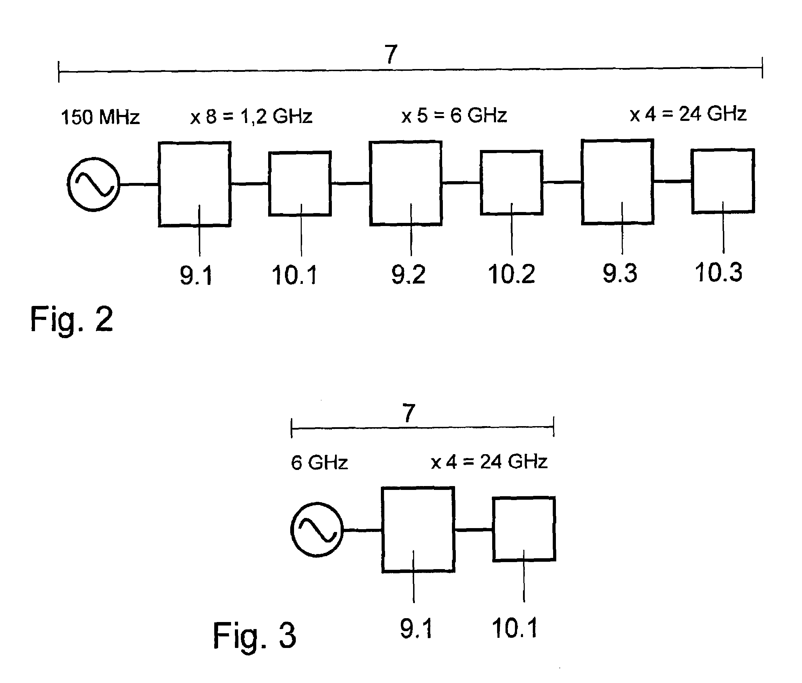

Ein Ausführungsbeispiel des Referenzoszillators 7 ist in Figur 2 dargestellt. Ein quarzstabiles Signal, z.B. ein Prozessortakt mit einer Frequenz von 150 MHz, das einer ersten Frequenz entspricht, ist abwechselnd an drei nichtlineare Verstärker 9.1, 9.2, 9.3 und zweite Filter 10.1, 10.2, 10.3 angekoppelt. Das Ausgangssignal des letzten Filters 10.3 entspricht der Frequenz des Referenzoszillators 7 von 24 GHz. Die erste Frequenz wird hier also insgesamt um den Faktor 160 vervielfacht, wobei die Einzelfaktoren z.B. acht, fünf und vier betragen (also 8 x 5 x 4 = 160). Die Verstärker 9.1, 9.2, 9.3 sind z.B. Transistoren oder Dioden.

Ein anderes Beispiel für den Referenzoszillator 7 ist aus Figur 3 ersichtlich. Hier ist ein von der Signalverarbeitungseinheit 2 kommendes, mittels eines PLL erzeugtes Signal mit einer Frequenz von 6000 MHz, das einer ersten Frequenz entspricht, an einen nichtlinearen Verstärker 9.4, und einen zweiten Filter 10.4 angekoppelt. Die erste Frequenz wird hierbei z.B. einmal um den Faktor vier vervielfacht, so dass die Frequenz am Ausgang des Referenzoszillators 24 GHz entspricht.

Bei einem bevorzugten Ausführungsbeispiel wird eine erste Frequenz von ca. 2,4 GHz von einem PLL- Oszillator erzeugt und auf die Sollfrequenz, die je nach Staat zwischen 24,0 und 24,35 GHz liegt, verzehnfacht.

Für den Referenzoszillator 7 sind viele weitere Ausführungen möglich in Abhängigkeit von der ersten Frequenz, der Soll- Frequenz sowie der Anzahl und Art der Verstärker.

Im Betrieb sendet und/oder empfängt die Sende- und Empfangseinheit Radarwellen mit einer modulierten Soll- Frequenz von z.B. 24 GHz auf bekannte Weise. Hierbei driftet ohne Korrekturmaßnahmen die tatsächliche Sendefrequenz, die von dem Oszillator 1 gesteuert wird, im Lauf der Zeit, so dass ein zulässiger Bereich verlassen wird. Um diese Drift zu kompensieren, wird in relativ großen zeitlichen Abständen von mehreren Minuten ein Kalibriervorgang durchgeführt, der wenige Millisekunden dauert.

Für den Kalibriervorgang wird der Referenzoszillator 7 von der Signalverarbeitungseinheit 2 angesteuert, so dass dieser die erste Frequenz erzeugt, über die Verstärker 9.1, 9.2, 9.3 oder 9.4 und Filter 10.1, 10.2, 10.3 oder 10.4 den Takt auf die Soll- Frequenz als Referenz vervielfacht und diese Referenz in den Empfangsteil der Sende- und Empfangseinheit einkoppelt. Der Oszillator 1 wird durch Verändern der Steuerspannung so in seiner Frequenz verstellt, dass die Signalverarbeitungseinheit 2 die Referenz an einem Empfängerausgang der Sende- und Empfangseinheit detektieren kann. Die so veränderte Steuerspannung wird gespeichert und im weiteren Betrieb des Oszillators 1 verwendet. Nach Beenden des Kalibriervorgangs wird der Referenzoszillator nicht weiter angesteuert, so dass dann der normale Betrieb der Sende- und Empfangseinheit erfolgt.

Der Kalibriervorgang wird in vorgegebenen oder variablen Zeitabständen wiederholt, so dass die tatsächliche Frequenz des Oszillators 1 weitestgehend mit der Soll- Frequenz übereinstimmt.

## Patentansprüche

1. Verfahren zur Stabilisierung einer Frequenz eines Oszillators (1) für hochfrequente Wellen einer Sende- und Empfangseinheit,
wobei der Oszillator (1) spannungsgesteuert ist,
**dadurch gekennzeichnet, dass** ein Signal eines Referenzoszillators (7) in einen Empfangsteil der Sende- und Empfangseinheit eingekoppelt und mit einer tatsächlichen Frequenz des Oszillators (1) verglichen wird, wobei diese gegebenenfalls korrigiert wird,
dass eine erste Frequenz konstant und stabil erzeugt wird und
dass die Frequenz des Referenzoszillators (7) durch Vervielfachung der ersten Frequenz erzeugt wird
und dass die Korrektur der Frequenz des Oszillators (1) durch Detektieren des Signals des Referenzoszillators (7) an einem Empfängerausgang erfolgt.

2. Verfahren nach Anspruch 1, **dadurch gekennzeichnet, dass** die Soll- Frequenz 24 bis 24,35 GHz beträgt.

3. Verfahren nach Anspruch 1 oder 2, **dadurch gekennzeichnet, dass** die erste Frequenz 150 MHz oder 1200 MHz oder 2400 MHz oder 6000 MHz beträgt.

4. Verfahren nach einem der Ansprüche 1 bis 3, **dadurch gekennzeichnet, dass** die erste Frequenz ca. 2400 MHz beträgt und in einem Schritt verzehnfacht wird.

5. Verfahren nach einem der Ansprüche 1 bis 3, **dadurch gekennzeichnet, dass** der Referenzoszillator (7) in zeitlichen Abständen von einer Steuereinheit (2) angesteuert wird.

6. Verfahren nach Anspruch 6, **dadurch gekennzeichnet, dass** der normale Betrieb der Sende- und Empfangseinheit während des Vergleichens und Korrigierens ausgeschaltet ist.

7. Verfahren nach Anspruch 6, **dadurch gekennzeichnet, dass** die Sende- und Empfangseinheit mehrere Empfangsteile aufweist und dass ein für das Vergleichen und Korrigieren ausgewähltes der Empfangsteile während dieser Vorgänge durch Ausschalten eines zugehörigen Verstärkerelements (6) vom normalen Betrieb abgekoppelt wird.

8. Verfahren nach einem der Ansprüche 1 bis 7, **dadurch gekennzeichnet, dass** eine veränderte Steuerspannung gespeichert und für den weiteren Betrieb des Oszillators (1) verwendet wird.

9. Sende- und Empfangseinheit für hochfrequente Wellen mit einem Oszillator (1) und mit einer Vorrichtung zur Stabilisierung einer Frequenz des Oszillators (1),
wobei der Oszillator (1) spannungsgesteuert ist,
**dadurch gekennzeichnet, dass** die Vorrichtung zum Stabilisieren
- einen Referenzoszillator (7), dessen Ausgang ein Signal in einen Empfangsteil der Sende- und Empfangseinheit einkoppelt,
- Mittel zum Vergleichen des Signals mit einer tatsächlichen Frequenz des Oszillators (1) und
- Mittel zum Korrigieren der tatsächlichen Frequenz des Oszillators (1) mit Hilfe des Signals umfasst,
dass Mittel zum Erzeugen einer konstanten und stabilen ersten Frequenz angeordnet sind,
dass der Referenzoszillator (7) Mittel zur Vervielfachung der ersten Frequenz zum Erzeugen der Soll- Frequenz als Signal aufweist
und dass die Mittel zum Korrigieren Mittel zum Detektieren des Signals des Referenzoszillators (7) an einem Empfängerausgang umfassen.

10. Sende- und Empfangseinheit nach Anspruch 9, **dadurch gekennzeichnet, dass** die Soll- Frequenz 24 bis 24,35 GHz beträgt.

11. Sende- und Empfangseinheit nach Anspruch 9 oder 10, **dadurch gekennzeichnet, dass** die erste Frequenz 150 MHz oder 1200 MHz oder 2400 MHz oder 6000 MHz beträgt.

12. Sende- und Empfangseinheit nach einem der Ansprüche 9 bis 11, **dadurch gekennzeichnet, dass** die erste Frequenz ca. 2400 MHz beträgt und dass die Mittel zur Vervielfachung elektronische Bauteile (9.1, 10.1) zur Verzehnfachung in einem Schritt aufweisen.

13. Sende- und Empfangseinheit nach einem der Ansprüche 9 bis 12, **dadurch gekennzeichnet, dass** ihre Signalverarbeitungseinheit (2) für das Vergleichen und Korrigieren Mittel zum Ansteuern des Referenzoszillators (7) in zeitlichen Abständen umfasst.

14. Sende- und Empfangseinheit nach Anspruch 13, **dadurch gekennzeichnet, dass** die Signalverarbeitungseinheit (2) Mittel zum Ausschalten des normalen Betriebs der Sende- und Empfangseinheit während des Vergleichens und Korrigierens umfasst.

15. Sende- und Empfangseinheit nach Anspruch 13, **dadurch gekennzeichnet, dass** die Sende- und Empfangseinheit mindestens zwei Empfangsteile umfasst und dass eines der Empfangsteile, das für das Vergleichen und Korrigieren ausgewählt ist, ein ausschaltbares Verstärkerelement (6) aufweist.

## Claims

1. Method of stabilizing a frequency of a voltage-controlled oscillator (1) for high-frequency waves of a transceiver unit, wherein a signal of a reference oscillator (7) is fed to the receiver circuit of the transceiver unit and compared with the actual frequency of the oscillator (1) such that the actual frequency may be corrected as necessary, wherein a first constant and stable frequency is generated, and wherein the frequency of the reference oscillator (7) is generated by multiplying the first frequency, and wherein the frequency of the oscillator (1) is corrected by detecting the signal of the reference oscillator (7) at a receiver output.

2. Method as in claim 1, wherein the target frequency is between 24 GHz and 24.35 GHz.

3. Method as in claim 1 or 2, wherein the first frequency is 150 MHz or 1200 MHz or 2400 MHz or 6000 MHz.

4. Method as in one of claims 1 to 3, wherein the first frequency is approx. 2400 MHz and multiplied by ten at a single step.

5. Method as in one of claims 1 to 3, wherein the reference oscillator (7) is actuated by a control unit (2) at timed intervals.

6. Method as in claim 6, wherein normal operation of the transceiver unit is disabled while frequencies are being compared and corrected.

7. Method as in claim 6, wherein the transceiver unit features several receiver circuits, and wherein a receiver circuit chosen to do the comparing and correcting is withdrawn from normal operation by turning off an allocated amplifier element (6) while these processes are in progress.

8. Method as in one of claims 1 to 7, wherein a modified control voltage is retained and used for further operation of the oscillator (1).

9. Transceiver unit for high-frequency waves featuring a voltage-controlled oscillator (1) and an implement for stabilizing a frequency of the oscillator (1), wherein the stabilizing implement is made up of a reference oscillator (7) whose output feeds a signal to a receiver circuit of the transceiver unit, means of comparing the signal with an actual frequency of the oscillator (1), and means of correcting the actual frequency of the oscillator (1) with reference to the signal received, wherein means of generating a constant and stable first frequency are available, wherein the reference oscillator (7) features means of multiplying the first frequency to generate a signal equivalent of the target frequency, and wherein the means of correction include means of detecting the signal of the reference oscillator (7) at a receiver output.

10. Transceiver unit as in claim 9, wherein the target frequency is between 24 GHz and 24.35 GHz.

11. Transceiver unit as in claim 9 or 10, wherein the first frequency is 150 MHz or 1200 MHz or 2400 MHz or 6000 MHz.

12. Transceiver unit as in one of claims 9 to 11, wherein the first frequency is approx. 2400 MHz, and wherein the means of multiplication include electronic components (9.1, 10.1) for multiplying the frequency by ten at a single step.

13. Transceiver unit as in one of claims 9 to 12, wherein the signal processor (2) for comparing and correcting includes means of actuating the reference oscillator (7) at timed intervals.

14. Transceiver unit as in claim 13, wherein the signal processor (2) includes means of disabling normal operation of the transceiver unit while comparing and correcting are in progress.

15. Transceiver unit as in claim 13, wherein the transceiver unit features at least two receiver circuits, and wherein one of the receiver circuits chosen to do the comparing and correcting has an amplifier element (6) which can be turned off.

## Revendications

1. Procédé de stabilisation d'une fréquence d'un oscillateur (1) pour les ondes à haute fréquence d'un appareil émetteur/récepteur, dans lequel l'oscillateur (1) est commandé par la tension,
**caractérisé en ce qu'**un signal d'un oscillateur de référence (7) dans une partie de réception de l'appareil émetteur/récepteur est injecté et comparé à une fréquence réelle de l'oscillateur (1), celle-ci étant le cas échéant corrigée,
**en ce qu'**une première fréquence constante et stable est générée, et
**en ce que** la fréquence de l'oscillateur de référence (7) est générée par multiplication de la première fréquence, et
**en ce que** la correction de la fréquence de l'oscillateur (1) se fait par la détection du signal de l'oscillateur de référence (7) au niveau d'une sortie de réception.

2. Procédé selon la revendication 1, **caractérisé en ce que** la fréquence théorique va de 24 à 24,35 GHz.

3. Procédé selon la revendication 1 ou la revendication 2, **caractérisé en ce que** la première fréquence est de 150 MHz ou 1200 MHz ou 2400 MHz ou 6000 MHz.

4. Procédé selon l'une des revendications 1 à 3, **caractérisé en ce que** la première fréquence est d'environ 2400 MHz et multipliée par dix en une étape.

5. Procédé selon l'une des revendications 1 à 3, **caractérisé en ce que** l'oscillateur de référence (7) est commandé à des intervalles de temps par un module de commande.

6. Procédé selon la revendication 6, **caractérisé en ce que** la fonction normale de l'appareil émetteur/récepteur est désactivée pendant la comparaison et la correction.

7. Procédé selon la revendication 6, **caractérisé en ce que** l'appareil émetteur/ récepteur présente plusieurs parties de réception et **en ce que** la fonction normale de l'une des parties de réception sélectionnée pour la comparaison et la correction est désactivée au cours de ces opérations en déconnectant un élément amplificateur (6) associé.

8. Procédé selon l'une des revendications 1 à 7, **caractérisé en ce qu'**une tension de commande modifiée est stockée et utilisée pour la poursuite du fonctionnement de l'oscillateur (1).

9. Appareil émetteur/récepteur pour ondes à haute fréquence, comprenant un oscillateur (1) et un dispositif de stabilisation d'une fréquence de l'oscillateur (1), l'oscillateur (1) étant commandé par la tension,
**caractérisé en ce que** le dispositif de stabilisation comprend
- un oscillateur de référence (7) dont la sortie injecte un signal dans une partie de réception de l'appareil émetteur/récepteur,
- des moyens pour comparer le signal à une fréquence réelle de l'oscillateur (1), et
- des moyens pour corriger la fréquence réelle de l'oscillateur (1) à l'aide du signal,
**en ce que** des moyens sont agencés de façon à générer une première fréquence constante et stable,
**en ce que** l'oscillateur de référence (7) présente des moyens pour multiplier la première fréquence afin de générer la fréquence théorique en tant que signal, et
**en ce que** les moyens de correction comprennent des moyens pour détecter le signal de l'oscillateur de référence (7) sur une sortie de réception.

10. Appareil émetteur/récepteur selon la revendication 9, **caractérisé en ce que** la fréquence théorique va de 24 à 24,35 GHz.

11. Appareil émetteur/récepteur selon la revendication 9 ou la revendication 10, **caractérisé en ce que** la première fréquence est de 150 MHz ou 1200 MHz ou 2400 MHz ou 6000 MHz.

12. Appareil émetteur/récepteur selon l'une des revendications 9 à 11, **caractérisé en ce que** la première fréquence est d'environ 2400 MHz et **en ce que** les moyens de multiplication présentent des composants électroniques (9.1, 10.1) pour effectuer une multiplication par dix en une étape.

13. Appareil émetteur/récepteur selon l'une des revendications 9 à 12, **caractérisé en ce que** son module de traitement du signal (2) pour la comparaison et la correction comprend des moyens pour exciter l'oscillateur de référence (7) par intervalles dans le temps.

14. Appareil émetteur/récepteur selon la revendication 13, **caractérisé en ce que** le module de traitement du signal (2) comprend des moyens pour désactiver la fonction normale de l'appareil émetteur/récepteur pendant la comparaison et la correction.

15. Appareil émetteur/récepteur selon la revendication 13, **caractérisé en ce que** l'appareil émetteur/récepteur comprend au moins deux parties de réception et **en ce que** l'une des parties de réception qui est sélectionnée pour la comparaison et la correction présente un élément amplificateur (6) qui peut être déconnecté.
